Europäisches Patentamt

European Patent Office

Office européen des brevets

(11) Publication number : **0 508 802 A1**

## (12) EUROPEAN PATENT APPLICATION

(21) Application number : **92303201.5**

(22) Date of filing : **10.04.92**

(51) Int. Cl.⁵ : **C08J 5/18,** H01L 45/00

(30) Priority : **11.04.91 JP 78998/91**

(43) Date of publication of application :
**14.10.92 Bulletin 92/42**

(84) Designated Contracting States :
**DE FR GB IT**

(71) Applicant : **CENTRAL GLASS COMPANY, LIMITED**
**5253, Oaza Okiube**
**Ube-city Yamaguchi-pref. (JP)**

(72) Inventor : **Tsutsumi, Kentaro, c/o Tokyo Research Center**
**Central Glass Company, Ltd., 2805, Imafukunakadai**
**Kawagoe City (JP)**
Inventor : **Komoriya, Haruhiko, c/o Tokyo Research Center**
**Central Glass Company, Ltd., 2805, Imafukunakadai**
**Kawagoe City (JP)**

(74) Representative : **Myerscough, Philip Boyd**
**J.A. Kemp & Co. 14 South Square, Gray's Inn**
**London WC1R 5LX (GB)**

(54) **Ferroelectric film of fluoroolefin copolymer and method of forming same.**

(57)    The invention provides a ferroelectric film of a copolymer which comprises at least 90 mol % of vinylidene fluoride and trifluoroethylene in a molar ratio of from 70 :30 to 90 :10 and which has
a number average molecular weight from $3 \times 10^4$ to $30 \times 10^4$,
a Curie point not lower than 70°C and an enthalpy change of not less than 5 J/g at said Curie point, and
another enthalpy change of not less than 24 J/g at a melting point determined by differential scanning calorimetry,
the film being formed from a solution of said copolymer.
    The film is formed by applying a 0.01-20 wt% solution of the copolymer in an ether to a substrate, drying the liquid film and baking the dried film at 70-160°C. The film has a high value of residual polarization and is useful, for example, in liquid crystal display devices.

EP 0 508 802 A1

Jouve, 18, rue Saint-Denis, 75001 PARIS

This invention relates to a ferroelectric film of a vinylidene fluoride based copolymer and a method of forming the film.

Ferroelectric ceramic materials and ferroelectric plastic materials are selectively used in various display devices. Ceramic materials are generally excellent in heat resistance but difficult to form into films with large areas. Plastic materials are relatively low in heat resistance, but some plastic materials can easily be formed into films with large areas.

In the field of liquid crystal display devices such as, for example, panel displays for personal computers of lap-top type there is a strong demand for color displays of improved performance, and major efforts are directed to the development of color displays of the active matrix type using a switching or driving element such as a thin-film transistor or a thin-film diode for each picture element. In particular, the use of thin-film diodes is expected to lead to a success in developing a practicable color display with a desirably large surface area.

However, it is not easy to form a large number of thin-film diode elements on an insulating substrate (usually a glass substrate) having a large surface area. In the case of a liquid crystal display device of the active matrix type using thin-film diode elements it is usual to employ a so-called MIM (metal-insulator-metal) structure, which is produced by forming a first set of electrodes on a glass substrate, overlaying a $Ta_2O_5$ film which serves as a ferroelectric layer on the first electrodes and forming a second set of electrodes on the $Ta_2O_5$ layer. The ferroelectric layer of $Ta_2O_5$ is usually formed by an anodic oxidation method, but by this method it is difficult to form a film having a desirably large surface area. Therefore, trials have been made to use a ferroelectric plastic material that can easily be formed into a film with a large area. However, still there is no ferroelectric plastic material that is fully satisfactory in the ferroelectric and other characeristics for use in display devices of the active matrix type and can easily be formed into a very uniform and smooth film.

It is an object of the present invention to provide a ferroelectric plastic film which has good properties and is useful as a ferroelectric layer, for example, in a liquid crystal display device of the active matrix type.

It is another object of the invention to provide a method of surely forming a defectless ferroelectric film according to the invention.

Recording to the invention there is provided a ferroelectric film of a copolymer which comprises vinylidene fluoride and trifluoroethylene as principal components that amount to at least 90 mol% of the copolymer on condition that the molar ratio of vinylidene fluoride to trifluoroethylene is in the range from 70:30 to 90:10, has a number average molecular weight in the range from $3 \times 10^4$ to $30 \times 10^4$ and a Curie point not lower than 70°C and exhibits an enthalpy change ($\Delta H_m$) not less than 24 J/g at a melting point determined by differential scanning calorimetry and another enthalpy change ($\Delta H_c$) not less than 5 J/g at the Curie point. The film is formed from a solution of the copolymer.

Further, the invention provides a method for producing a ferroelectric film which is stated above. The method comprises the steps of dissolving the above-speeified copolymer in an organic solvent which comprises at least 90 wt% of an ether so as to obtain a solution in which the concentration of the copolymer is in the range from 0.1 to 20 wt%, applying the solution to a substrate thereby forming a liquid film on the substrate, drying the liquid film to remove the solvent, and baking the dried film at a temperature in the range from 70 to 160°C.

According to the invention the material of a ferroelectric film is a copolymer of vinylidene fluoride (VDF) and trifluoroethylene (TrFE), though the copolymer can optionally incorporate not more than 10 mol% of another fluoroolefin or a fluoroketone as will be described hereinafter.

For a ferroelectric layer in a liquid crystal display device of the active matrix type, an important requirement is that the value of residual polarization ($P_r$) should be as large as possible since the electric characteristics of the device become better as the value of $P_r$ becomes larger . The value of $P_r$ does not become large unless the material of the ferroelectric layer exhibits high ferroelctricity. In the case of a copolymer of VDF and TrFE, one of the essential conditions is that the copolymer has the β-type crystal structure and another is that cooperative dislocation of $-CF_2-$ dipoles in the copolymer crystals and adequate interaction of the $-CF_2-$ dipoles in the adjacent molecules take place. In this copolymer $-CF_2-$dipoles are attributed to VDF, and both the degree of interaction of the dipoles and the stability of the β-type crystal structure depend on the amount of TrFE. The present invention specifies that the molar ratio of VDF to TrFE should be in the range from 70:30 to 90:10. If the proportion of TrFE is less than 10 mol% the the copolymer loses ferroelectricity by reason of an increase in helical crystals (α-type crystals). If the proportion of TrFE is more than 30 mol% the interaction of $-CF_2-$ dipoles in the adjacent molecules becomes so weak that the copolymer exhibits paraelectricity at room temperature and fails to exhibit ferroelectricity necessary for the present invention.

The copolymer used in this invention must have a number average molecular weight ($M_n$) ranging from $3 \times 10^4$ to $30 \times 10^4$. If $M_n$ is below $3 \times 10^4$ a film of the copolymer is insufficient in the strength of adhesion to a substrate or an underlying layer and liable to peel off or crack. If $M_n$ is above $30 \times 10^4$ the copolymer becomes low in solubilities in organic solvents and hence cannot easily be formed into a film. The copolymer is required to have a Curie point which is not lower than 70°C. If the Curie point is below 70°C the copolymer does not exhibit sufficiently high ferroelectricity.

The copolymer film according to the invention must exhibit an enthalpy change ($\Delta H_m$) not less than 24 J/g at a melting point determined by differential scanning calorimetry (DSC) and an enthalpy change ($\Delta H_c$) not less than 5 J/p at the Curie point. If the amount of $\Delta H_m$ is less than 24 J/g the copolymer film is insufficient in crystallinity. If the amount of $\Delta H_c$ is less than 5 J/g the copolymer film does not exhibit sufficientty high ferroelectricity and hence is not large in the value of residual polarization ($P_r$).

According to the invention a film of the VDF-TrFE copolymer is formed from a solution of the copolymer in an ether such as, for example, dioxane. The use of an ether is an essential condition of forming a ferroelectric copolymer film having a microscopically uniform and smooth surface.

A ferroelectric plastic film according to the invention is sufficiently large in the value of residual polarization ($P_r$) and hence is useful, for example, in a liquid crystal display device of the active matrix type as a ferroelectric layer to form thin-film diodes as switching or driving elements.

In principle the present invention uses binary copolymer of VDF and TrFE. However, it is possible to modify the binary copolymer by copolymerizing a small amount of an auxiliary component. As the auxiliary component it is suitable to choose a fluoroolefin such as tetrafluoroethylene, chlorotrifluoroethylene, vinyl fluoride or hexafluoropropene or a fluoroketone represented by hexafluoroacetone. The incorporation of such an auxiliary component serves the purpose of improving the crystallinity of a film of the copolymer and the adhesion of the copolymer film to a substrate or an underlying electrode layer, but the auxiliary component adversely affects the ferroelectricity of the copolymer. In the modified copolymer the maximum amount of the auxiliary component should be limited to 10 mol% of the total of VDF and TrFE.

A copolymer for use in this invention can be prepared by copolymerizing VDF and TrFE, and another fluoroolefin or a fluoroketone if desired, by a conventional radical polymerization process in the manner of solution polymerization, suspension polymerization or emulsion polymerization. The liquid medium for the reaction can be selected from water, alocohols such as t-butanol and isopropanol, saturated hydrocarbons such as n-hexane and n-heptane, halogenated hydrocarbons such as trichlorotrifluoroethane and dichlorotetrafluoroethane, ketones such as acetone, methylethyl ketone and methylisobutyl ketone and esters such as ethyl acetate and butyl acetate, and according to the need a mixed liquid can be used. A conventional radical polymerization initiator is used. For example, a selection is made from dicarbonates such as diisopropyl peroxydicarbonate, di-2-ethylhexyl peroxydicarbonate and di-n-propyl peroxydicarbonate, diacyl peroxides such as n-heptafluorobutyric peroxide, lauroyl peroxypivalate and t-butyl oxyneodecanoate, alkyl peroxides such as di-t-butyl peroxide and t-butylcumyl peroxide and 2,2′-azobisisobutyronitrile. An optimum temperature for the polymerization depends on the kind of the radical polymerization initiator, but in general the reaction temperature is in the range from 0 to 130°C.

To form a ferroelectric film according to the invention a solution of the above described VDF-TrFE copolymer is applied to a substrate. In the case of forming a film having a large surface area it is preferable to employ a spin coating method. A film formed by this method is very thin compared with the surface area. That is, the film is an almost two-dimensional film, and hence in this film the direction of growth of the copolymer crystals is limited. Therefore, the film forming condition becomes an important factor in obtaining a film having desired ferroelectric characteristics.

According to the invention particular attention is paid to the organic solvent for preparing a solution of the VDF-TrFE copolymer, and an ether is used to form a good film from the solution. In the conventional coating methods using a solution of a fluoroolefin based copolymer it is usual to use a ketone as the solvent. However, when a film of the VDF-TrFE copolymer is formed from a solution in a ketone the film is not really good from all aspects. That is, by observation with the naked eye the film seems to be uniform and smooth, but microscopically the film has a number of island-like regions each of which is an agglomerate of innumerable islets. The island-like regions exist even before curing the film and further augment by heat treatment for curing the film. In the film having such island-like regions the crystallinity of the VDF-TrFE copolymer remains insufficient, and when the film is used in the driving or switching elements of a liquid crystal display device of active matrix type there occurs nonuniformity of electric field whereby the electric characteristics of the device are marred.

According to the invention an ether is used as the solvent for preparing a solution of the VDF-TrFE copolymer to form a uniformly smooth film which is free of island-like regions. Suitable ethers are n-dibutyl ether, tetrahydrofuran, tetrahydropyran, dioxane and trioxane, and particularly dioxane is preferred. According to the need it is permissible to mix a small amount of a cyclic ketone such as cyclohexanone, cycloheptanone or cyclopentanone with the ether for the purpose of adjusting the viscosity, stability or evaporation rate of the solvent. In the case of such a mixed solvent the maximum amount of the optional cyclic ketone is limited to 10 wt%.

In the solution the concentration of the VDF-TrFE copolymer should be from 0.1 to 20 wt%. When the concentration is below 0.1 wt% it is likely that a film formed by an ordinary coating method is too thin. When the concentration is above 20 wt% it is likely that the obtained film is uneven in thickness.

The solution is applied to a substrate by a spin coating or an alternative coating method to form a liquid film on the substrate. Then the liquid film is dried at room temperature or under mild heating until the solvent is completely removed. The dried film is baked at a temperature in the range from 70 to 160°C and below the melting temperature of the copolymer. By this baking operation the copolymer film becomes dense and crystalline. If the baking temperature is above 160°C the film fluidifies, and the film does not easily crystallize. If the baking temperature is below 70°C it means that the baking temperature is below the ferroelectric transition point of the copolymer, and it takes a very long time to crystallize the film.

EXAMPLE 1

A binary copolymer of VDF and TrFE was prepared by the following process.

An autoclave having a capacity of 1liter was charged with 600 ml of 1,1,2-trichloro-1,2,2-trifluoroethane (CFC-113). Then the gas atmosphere in the autoclave was replaced by nitrogen gas while stirring CFC-113, and the nitrogen gas was purged from the autoclave, and this operation was repeated twice. After that 48 g of VDF and 29 g of TrFE were charged in the autoclave, and the temperature in the autoclave was adjusted to 20°C. As a radical polymerization initiator, 18 g of 5 wt% solution of heptafluorobutyric peroxide in CFC-113 was added. After that the mixture in the autoclave was continuously stirred for 20 hr at a constant temperature of 25°C ($\pm$1°C) to carry out polymerization reaction. After the reaction the residual gas was purged from the autoclave.

The product of the above polymerization reaction was a VDF-TrFE copolymer in the form of a slurry. The slurry was discharged from the autoclave and subjected to solid-liquid separation to obtain a cake of the copolymer. The cake was washed with methanol, and the washed copolymer was collected by filtration and dried. The dry weight of the copolymer was 64 g, which means 86% yield.

The obtained copolymer was composed of 70 mol% of VDF and 30 mol% of TrFE and had a number average molecular weight $M_n$ of 9 x 10$^4$. The molecular weight was determined by GPC, assuming the copolymer to be polystyrene.

EXAMPLES 2-6

In these examples the copolymerization process of Example 1 was repeated except that the proportion of VDF to TrFE was varied as shown in Table 1 and that the polymerization reaction temperature was varied in order to control the molecular weight of the copolymer. The molecular weight became 3 x 10$^4$ by reacting at 30°C, from 8 x 10$^4$ to 10 x 10$^4$ by reacting at 25°C and 30 x 10$^4$ by reacting at 17°C.

Each of the copolymers obtained in Examples 1-6 was formed into a film from a solution in dioxane, and the film was subjected to DSC analysis to determine the Curie point, melting point, an enthalpy change at the melting point, $\Delta H_m$, and an enthalpy change at the Curie point, $\Delta H_c$. Besides, on a film of each copolymer the value of residucal polarization, $P_r$, was measured by the C-V method. Each sample film was formed on a 50-mm square glass substrate on which an ITO film having resistance of about 10 $\Omega/\square$ was coated in advance by applying a solution of the copolymer in dioxane to the substrate by a spin coating method, drying the sol film and baking the dried film for 1 hr at a temperature higher than the Curie point of the copolymer by about 10°C. After that a 2-mm square electrode of aluminum was formed on the copolymer film by vacuum evaporation. The thickness of each copolymer film was 4000-5000 Å.

COMPARATIVE EXAMPLES 1-4

The copolymerization process of Example 1 was repeated except that the proportion of VDF to TrFE was varied as shown in Table 1 and that the reaction temperatrue was varied to control the molecular weight of the copolymer.

Each of the copolymers of Comparative Examples 1 and 2 was formed into a film from a solution in dioxane, and each of the copolymers of Comparative Examples 3 and 4 was formed into a film from a solution in acetone. On each of these copolymer films the Curie point, melting point, $\Delta H_m$, $\Delta H_c$ and $P_r$ were as shown in Table 1.

TABLE 1

| | Composition (mol%) | | $M_n$ (x10^4) | M.P. (°C) | Curie Point (°C) | $\Delta H_m$ (J/g) | $\Delta H_c$ (J/g) | $P_r$ (mC/m²) |
|---|---|---|---|---|---|---|---|---|
| | VDF | TrFE | | | | | | |
| Ex. 1 | 70 | 30 | 9 | 153 | 70 | 24 | 12 | 90 |
| Ex. 2 | 75 | 25 | 8 | 151 | 90 | 24 | 17 | 102 |
| Ex. 3 | 80 | 20 | 3 | 148 | 116 | 24 | 19 | 109 |
| Ex. 4 | 80 | 20 | 9 | 149 | 114 | 24 | 20 | 110 |
| Ex. 5 | 85 | 15 | 30 | 146 | 140 | 30 | 20 | 110 |
| Ex. 6 | 90 | 10 | 10 | 152 | 148 | 25 | 5 | 102 |
| Comp. Ex. 1 | 95 | 5 | 6 | 159 | | 19 | | 45 |
| Comp. Ex. 2 | 65 | 35 | 10 | 155 | 68 | 24 | 10 | 50 |
| Comp. Ex. 3 | 85 | 15 | 30 | 146 | 139 | 21 | 12 | 72 |
| Comp. Ex. 4 | 80 | 20 | 4 | 148 | 112 | 24 | 3 | 75 |

EXAMPLES 7-9

The copolymer of Example 1 (Copolymer No. 1), the copolymer of Example 3 (Copolymer No. 3) and the copolymer of Example 5 (Copolymer No. 5) were used in Examples 7, 8 and 9, respectively.

In each example the copolymer was dissolved in dioxane to prepare a solution of a predetermined concentration, which ranged from 3 to 15 wt% as shown in Table 2. The solution was applied to a glass plate by spin coating at a spinning rate of 5000 rpm. The spin coating operation was performed for 40 sec. The liquid film on the glass plate was left standing at room temperature for 20 min to allow the solvent to evaporate. Then the surface of the copolymer film was observed with optical microscope to examine whether island-like regions exist or not. After that each copolymer film was cured by baking for 1 hr at a predetermined temperature, which ranged from 90 to 140°C as shown in Table 2. The surface of the cured film was observed with optical microscope to examine whether island-like regions exist or not. The results are shown in Table 2, wherein: "A" means that no island-like region was perceptible; "B" means the existence of slight island-like regions; and "C" means the existence of a number of heavy island-like regions. Besides, the strength of adhesion of each film to the glass substrate was tested by the cross-cut adhesion test according to JIS K 5400, and the result is indicated in Table 2 by the number of no peel areas among 100 areas tested with cellophane tape.

COMPARATIVE EXAMPLE 5 AND 6

The copolymer No. 5 was used in these comparative examples, and the film forming process of Example 9 was modified in the following points.

In Comparative Example 5 acetone was used to prepare 10 wt% solution of the copolymer. In Comparative Example 6, which used dioxane to prepare 10 wt% solution of the copolymer, the copolymer film on the glass plate was bake cured at 60°C.

In each case the copolymer film was observed with optical microscope before and after curing, and the cross-cut adhesion test was made on the cured film. The results are shown in Table 2.

TABLE 2

| | Copolymer | Solution | | Appearance of Uncured Film | Curing Condition | | Appearance of Cured Film | Adhesion |
|---|---|---|---|---|---|---|---|---|
| | | Solvent | Concentration (wt%) | | Temp. (°C) | Time (hr) | | |
| Ex. 7 | No. 1 | dioxane | 10 | A | 90 | 1 | A | 100/100 |
| Ex. 8 | No. 3 | dioxane | 3 | A | 140 | 1 | A | 100/100 |
| Ex. 9 | No. 5 | dioxane | 15 | A | 140 | 1 | A | 100/100 |
| Comp. Ex. 5 | No. 5 | acetone | 10 | B | 120 | 1 | C | 100/100 |
| Comp. Ex. 6 | No. 5 | dioxane | 10 | A | 60 | 1 | A | 75/100 |

**Claims**

1. A ferroelectric film of a copolymer which comprises at least 90 mol % of vinylidene fluoride and trifluoroethylene in a molar ratio of from 70:30 to 90:10 and which has

a number average molecular weight from $3 \times 10^4$ to $30 \times 10^4$,

a Curie point not lower than 70°C and an enthalpy change of not less than 5 J/g at said Curie point, and

another enthalpy change of not less than 24 J/g at a melting point determined by differential scanning calorimetry,

the film being formed from a solution of said copolymer.

2. A film according to claim 1, wherein said copolymer is a binary copolymer of vinylidene fluoride and trifluoroethylene.

3. A film according to claim 1, wherein said copolymer further comprises at least one of tetrafluoroethylene, chlorotrifluoroethylene, vinyl fluoride, hexafluoropropene and hexafluoroacetone.

4. A method of producing a film as claimed in any one of claims 1 to 3, which method comprises:

dissolving said copolymer in an organic solvent comprising at least 90 wt% of an ether so as to obtain a solution in which the concentration of said copolymer is from 0.1 to 20 wt%;

applying said solution to a substrate thereby forming a liquid film on said substrate;

drying said liquid film to remove said organic solvent; and

baking the dried film on said substrate at a temperature from 70 to 160°C.

5. A method according to claim 4, wherein said ether is n-dibutyl ether, tetrahydrofuran, tetrahydropyran, dioxane or trioxane.

6. A method according to claim 4 or 5, wherein said solution further comprises not more than 10 wt% of a cyclic ketone.

7. A method according to claim 6, wherein said cyclic ketone is cyclohexanone, cycloheptanone or cyclopentanone.

8. A method according to any of claims 4 to 7, wherein said solution is applied to said substrate by spin coating.

9. An article having a film as claimed in any one of claims 1 to 3 on at least one surface thereof.

10. A ferroelectric film of a copolymer which comprises at least 90 mol % of vinylidene fluoride and trifluoroethylene in a molar ratio of from 70:30 to 90:10 and which has

a number average molecular weight from $3 \times 10^4$ to $30 \times 10^4$,

a Curie point not lower than 70°C and an enthalpy change of not less than 5 J/g at said Curie point, and

another enthalpy change of not less than 24 J/g at a melting point determined by differential scanning calorimetry.

European Patent
Office

**EUROPEAN SEARCH REPORT**

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5 ) |
|---|---|---|---|
| X | WORLD PATENTS INDEX LATEST<br>Week 8851,<br>Derwent Publications Ltd., London, GB;<br>AN 88-363214<br>& JP-A-63 271 431 (TORAY IND INC) 9 November 1988<br>* abstract * | 1,2,9,10 | C08J5/18<br>H01L45/00 |
| Y | EP-A-0 321 962 (SEIKO EPSON CORP) 28 June 1989<br>* page 4, column 5, line 34 - column 6, line 27 * | 4-6 | |
| X | WORLD PATENTS INDEX LATEST<br>Week 8744,<br>Derwent Publications Ltd., London, GB;<br>AN 87-311212<br>& JP-A-62 220 924 (CANON KK) 29 September 1987<br>* abstract * | 1,2,9,10 | |
| X | PATENT ABSTRACTS OF JAPAN<br>vol. 14, no. 449 (P-1111)26 September 1990 (<br>SEIKO EPSON CORP ) 11 July 1990<br>& JP-A-2 178 633 | 1,2,8-10 | |
| Y | * abstract * | 4-6 | TECHNICAL FIELDS SEARCHED (Int. Cl.5 )<br><br>G02F<br>C08J<br>H01G |
| X | PATENT ABSTRACTS OF JAPAN<br>vol. 10, no. 69 (E-389)18 March 1986 ( TORAY KK<br>) 31 October 1985<br>& JP-A-60 217 674<br>* abstract * | 1,2,9,10 | H01L |
| X | PATENT ABSTRACTS OF JAPAN<br>vol. 9, no. 175 (C-292)19 July 1985 ( KUREHA KAGAKU KOGYO KK ) 14 March 1985<br>& JP-A-60 047 034<br>* abstract * | 1,2,9,10 | |
| | -/-- | | |

The present search report has been drawn up for all claims

| Place of search | Date of completion of the search | Examiner |
|---|---|---|
| THE HAGUE | 20 JULY 1992 | GOERKE H.R. |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

 
& : member of the same patent family, corresponding
    document

EPO FORM 1503 03.82 (P0401)

EP 0 508 802 A1

| | European Patent Office | EUROPEAN SEARCH REPORT | Application Number |
|---|---|---|---|

EP 92 30 3201
Page 2

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| X | PATENT ABSTRACTS OF JAPAN vol. 9, no. 165 (E-327)10 July 1985 ( KUREHA KAGAKU KOGYO KK ) 4 March 1985 & JP-A-60 041 274 * abstract * | 1,3,9,10 | |
| A | PATENT ABSTRACTS OF JAPAN vol. 7, no. 148 (E-184)29 June 1983 ( TORAY KK ) 11 April 1983 & JP-A-58 060 585 * abstract * | 1-10 | |
| A | PATENT ABSTRACTS OF JAPAN vol. 11, no. 130 (E-502)23 April 1987 ( CENTRAL GLASS CO LTD ) 6 December 1986 & JP-A-61 276 280 * abstract * | 1-10 | |
| A | US-A-4 778 867 (SEYMOUR PREIS) 18 October 1988 | 1-10 | |
| A | EP-A-0 118 757 (DAIKIN KOGYO KK) 19 September 1984 | 1-10 | TECHNICAL FIELDS SEARCHED (Int. Cl.5) |

The present search report has been drawn up for all claims

| Place of search | Date of completion of the search | Examiner |
|---|---|---|
| THE HAGUE | 20 JULY 1992 | GOERKE H. R. |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P0401)